# EUROPEAN PATENT SPECIFICATION

(11) **EP 2 154 727 B1**
(45) Date of publication and mention of the grant of the patent: **27.03.2019**
(21) Application number: 09009038.2
(22) Date of filing: 10.07.2009
(51) Int. Cl.: H01L 31/0216, H01L 31/0236, H01L 31/048

(54) **Solar cells provided with color modulation and method for fabricating the same**
Solarzellen mit Farbanpassung und Verfahren zu ihrer Herstellung
Cellules solaires fournies avec une modulation de couleur et son procédé de fabrication

(30) Priority: 14.08.2008 US 88779 P; 19.05.2009 US 468606
(43) Date of publication of application: 17.02.2010
(73) Proprietor: LOF Solar Corporation, Hsinchu City (TW)
(72) Inventor: Hwang, Huey-Liang, Hsinchu City 300777 (TW); Lee, Cheng-Chung, Hsinchu City 300777 (TW); Hwang, Naejye, Hsinchu City 300777 (TW); Yang, Hsiang-Chih, Hsinchu City 300777 (TW); Sung, Meng-Hsun, Hsinchu City 300777 (TW)
(74) Representative: Straus, Alexander

(56) References cited:
- EP-A2- 2 051 124
- WO-A1-2004/038462
- DE-A1- 3 447 635
- DE-A1- 19 526 733
- DE-U1-202006 014 595
- JP-A- 6 037 343
- JP-A- 60 148 174
- JP-A- 2003 197 937
- JP-B2- 3 169 799
- US-A- 5 807 440
- US-A1- 2006 130 891

## Description

### BACKGROUND OF THE INVENTION

### Field of the Invention

The present inventions relates to photovoltaic cells capable of converting solar radiation into usable electrical energy. More specifically, the present invention relates to solar cells provided with color modulation and a method for fabricating the same.

### Description of the Related Art

Solar cells or photovoltaic cells are devices that convert light energy of sunlight into electrical energy by means of photoelectric conversion mechanism. From the view point of global environmental conservation, the solar cell is highly expected to generate electricity and actively developed for widespread commercialization in recent years. Buildings, vehicles and other objects may be covered in part with solar cells to maximize the use of solar energy. For decorative or aesthetic reasons, solar cell units may be required to have different colors. As an example, when the solar cells are employed to cover roofs or walls of buildings, different colors may be required for being integrated into the color(s) of the buildings or surrounding environment in consideration of design choice or aesthetic appearance.

Conventional approaches, such as US Patent Nos. 5,725,006 and 6,049,035, for providing solar cells with different colors may require additional manufacturing process or may deteriorate the photoelectric conversion efficiency of the solar cells. Therefore, it is desirable to provide solar cells with variable colors without complicated designs or processes or without too much impact on the solar power conversion efficiency thereof.

From DE 195 26 733 A1 a patterned solar cell is known, where by removing certain areas of a photoresist layer and corresponding parts of an underneath anti-reflection layer, a specific pattern on the surface of the solar cell is achieved. The layer of photo-resist and ant-reflection is removed by etching.

In JP 06 037343 solar cell elements of different groups are being arranged in the shape of mosaic in order to give a design property to a solar cell device. The solar cells of different groups have different light receiving capacities, thereby providing different colours to the human eye.

In order to colour a solar cell, JP 60 148174 discloses a selective reflecting layer consisting of multi-layer interference filters formed on a solar cell. The selective reflective layer selectively reflects beams having a specific wavelength in visible rays and transmits residual beams.

EP 2 051 124 A2 describes a photovoltaic device with integrated colour interferometric film stacks. The interferometric stacks can be configured to reflect light of a selected wavelength so as to impart a colour, while enough light is being transmitted to the photovoltaic active material in order to generated electricity.

Note that, Document JP 2003 197937 A discloses a solar cell comprising anti-reflection films for exhibiting desired colors. However, this document does not disclose forming a color-modulating layer to overlie the electrode disposed on the anti-reflection layer.

### SUMMARY OF THE INVENTION

One objective of the present invention is to provide solar cells provided with color modulation and a method for fabricating the same. The solar cell includes a photoelectric conversion layer and a color-modulating layer provided over the photoelectric conversion layer. The photoelectric conversion layer is employed for generating electrical energy from incident light and the color-modulating layer is used to modulate colorful appearance or enhance photoelectric conversion efficiency.

One embodiment of the present invention discloses solar cell comprising:
- a photoelectric conversion layer for generating electrical energy from incident light;
- an anti-reflection layer formed over the photoelectric conversion layer;
- at least one first electrode and at least one second electrode formed over the photoelectric conversion layer for outputting the electrical energy. The at least one first electrode is provided in contact with the photoelectric conversion layer through the anti-reflection layer, and a part of the first electrode is disposed on a top surface of the anti-reflection layer. The solar cell further comprises:
   - a color-modulating layer uniformly deposited over the anti-reflection layer to modulate colorful appearance thereof, wherein the color modulating layer overlies the at least one first electrode. The color-modulating layer is composed of a plurality of films, and the color-modulating layer is thicker than the anti-reflection layer.

According to one embodiment, the solar cell in accordance with the present invention further comprises a passivation layer formed over the color-modulating layer and a transparent layer formed over the passivation layer.

Another embodiment of the present invention discloses a method for fabricating a solar cell comprising the steps of:
- providing a photoelectric conversion layer;
- forming an anti-reflection layer on the photoelectric conversion layer;
- forming at least one first electrode and at least one second electrode over the photoelectric conversion layer, wherein the first electrode is formed on the anti-reflection layer;
- performing a heat treatment to the first electrode and the first electrode passing through the anti-reflection layer to be in contact with the photoelectric conversion layer by spiking effect; and
- uniformly depositing a color-modulating layer over the photoelectric conversion layer and over the at least one first electrode to modulate colorful appearance thereof.

The method may further comprise the steps of forming a passivation layer over the color-modulating layer and forming a transparent layer over the passivation layer.

Further embodiments are disclosed in the appending claims.

### BRIEF DESCRIPTION OF THE DRAWINGS

Other features and advantages of the present invention will be apparent from the detailed description of the invention that follows, taken in conjunction with the accompanying drawings of which:
Figures 1-5 schematically illustrate a process for fabricating solar cells in accordance with one preferred embodiment of the present invention in cross-sectional views of partial presentation;
Figure 6 illustrates the reflective spectrum of a solar cell as exemplified in Example I;
Figure 7 illustrates the refractive index vs. wavelength curve of a color-modulating layer in Example II;
Figure 8 illustrates the reflective spectrum of a solar cell as exemplified in Example II;
Figure 9 illustrates the refractive index vs. wavelength curve of a color-modulating layer in Example III;
Figure 10 illustrates the reflective spectrum of a solar cell as exemplified in Example III; and
Figure 11 illustrates the reflective spectrum of a solar cell as exemplified in Example IV

### DETAILED DESCRIPTION OF PREFERRED EMBODIMENT

Certain terms are used through the description and following claims to refer to particular elements. As one skilled in the art will appreciate, solar cell manufacturers may refer to a element by different names. This document does not intend to distinguish between elements that differ in name but not function. In the following description and in the claims, the terms "include" and "comprise" are used in an open-ended fashion, and thus should be interpreted to mean "include, but not limited to..." Also, the term "formed on" or formed over" are intended to mean either indirect or direct contact between two layers. Accordingly, if an upper layer is "formed on" or "formed over" a lower layer, two layers may be direct contact with each other, or an intermediate layer may be inserted or deposed between the two layers.

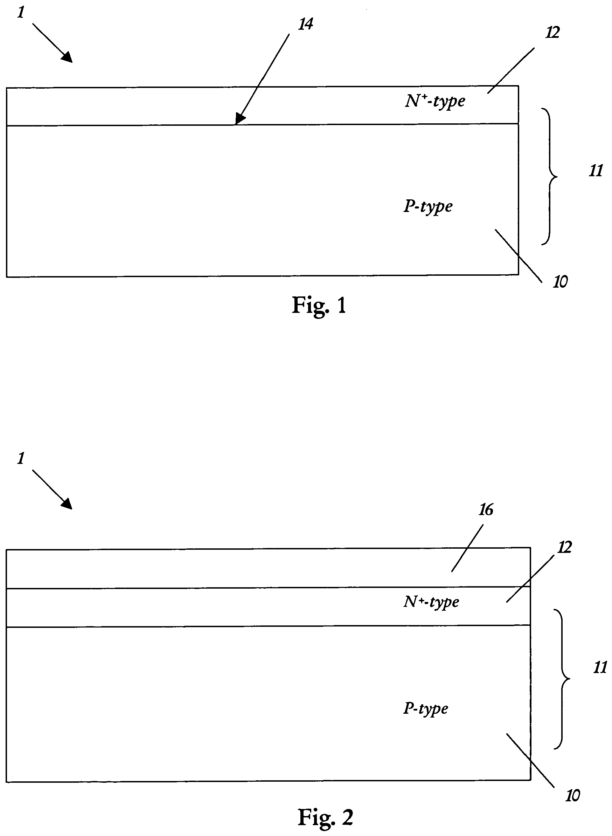

Figures 1 through 5 schematically illustrates the process flow for fabricating a solar cell unit 1 according to one preferred embodiment of the present invention in cross-sectional views of partial representation. Referring to Figure 1, an n-type semiconductor layer 12 is formed on a p-type semiconductor substrate 10 so as to form a p-n junction 14 therebetween. As such, an electric field can be established at the p-n junction 14. Light striking on this electric field may separate the positive charge carriers and the negative charge carriers, thus creating an electrical current passing through the p-n junction 14, which is so-called photoelectric conversion mechanism. Generally speaking, the combination of the p-type semiconductor substrate 10 and the n-type semiconductor layer 12 constitutes a photoelectric conversion layer 11 which is employed to generate electrical energy from incident light. The p-type semiconductor substrate 10 may be a p-type silicon substrate such that the n-type semiconductor layer 12 can be conformably deposited over the p-type semiconductor substrate 10 or formed by means of doping n-type impurities into the p-type semiconductor substrate 10. Alternately, an n-type semiconductor substrate in combination of a p-type semiconductor layer can be utilized to constitute the photoelectric conversion layer 11 as well. Generally speaking, the photoelectric conversion layer 11 may be made of one or more semiconductor materials, such as single crystalline, polycrystalline, amorphous state of semiconductor material such as silicon, germanium or the like.

As shown in Figure 2, the transparent anti-reflection layer 16 is formed over the photoelectric conversion layer 11 and may be made of silicon nitride by means of an evaporation method, a sputtering method, a print screen method, a CVD method or any other methods that are known to the persons skilled in the art. The anti-reflection layer 16 is employed to protect the solar cell unit 1 and also decreases reflective loss on the unit surface. Preferably, the anti-reflection layer 16 has a thickness ranging from 1nm to 500nm.

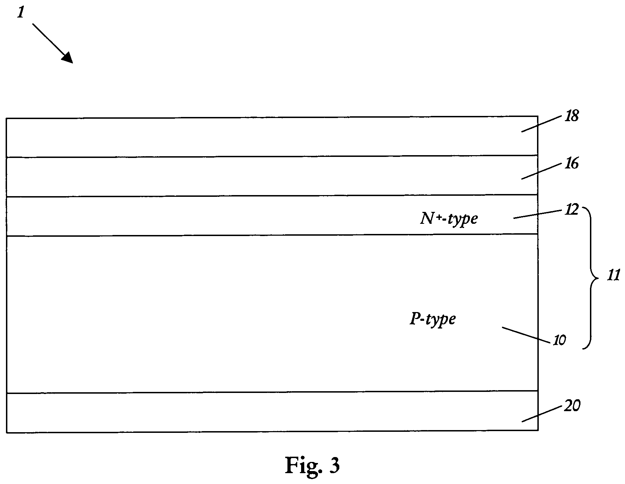

Conductive layers 18 and 20 are thereafter formed over opposite surfaces of the photoelectric conversion layer 11 by an evaporation method, a sputtering method, a print screen method, a CVD method or any other methods that are known to the persons skilled in the art. As shown in Figure 3, the conductive layer 18 is formed over the front surface of the photoelectric conversion layer 11 and, therefore, on the anti-reflection layer 16. The conductive layer 20 is formed over the back surface of the photoelectric conversion layer 11 in contact with the p-type substrate 10. The conductive layer 18 or 20 may be made of metal or alloy, for example, gold, silver, aluminum, copper, or platinum or the like, and could be made of transparent conductive oxide (TCO) layer such as ITO film or a ZnO film as well.

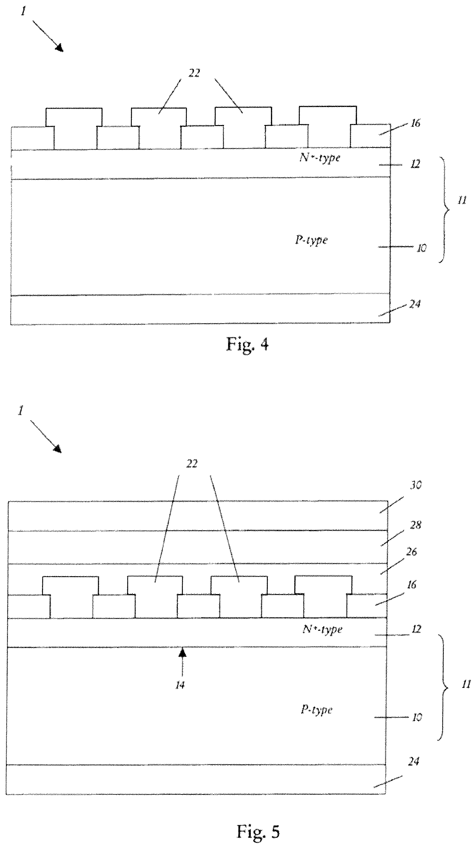

The conductive layer 18 can be subject to heat treatment such that conductive material contained in the conductive layer 18 can pass through the anti-reflection layer 16 to be in contact with the n-type semiconductor layer 12 by means of spiking effect. In addition, the conductive layers 18 and 20 can be patterned into parallel lines to form front electrodes 22 and back electrodes 24 respectively. As shown in Figure 4, the front electrodes 22 are electrically connected with the n-type semiconductor layer 12 and the back electrodes 24 are electrically connected to the p-type semiconductor substrate 10. Accordingly, the front electrodes 22 and the back electrodes 24 are formed to become two electrical terminals for the photoelectric conversion layer 11. In other words, the electrodes 22 and 24 are used to charge or discharge the electrical energy generated from the photoelectric conversion layer 11 if the solar cell unit 1 is subject to light of sunlight. Preferably, the back electrodes 24 may be formed into various shapes or structures, such as a concavo-convex structure, to facilitate light collection. Moreover, the front electrodes 22 may be formed so as to have a surface-textured structure including a rough surface structure, or so-called textured pattern. When the surface of the electrodes 22 are provided with such a textured pattern, the incidence efficiency of light into the photoelectric conversion layer 11 can be improved.

According to the present invention, the color-modulating layer 26 is formed over the anti-reflection layer 16 so as to provide the solar cell unit 1 with variable colors. The color-modulating layer 26 may be composed of one or more dielectric material over the anti-reflection layer 16 under a vacuum or near-vacuum environment by a coating method, an evaporation method (such as e-gun), a sputtering method, a CVD method or other methods if suitable and feasible.

Various dielectric materials or combination of thereof may be utilized. In some examples, materials such as oxides (SnO₂, Al₂O₃, SiO₂, ZnO, Y₂O₃, Ta₂O₅, TiO₂, Cr₂O₃, etc.), fluorides (MgF₂, Na₃AlF₆, etc.), sulphides (ZnS, PbS, CdS, etc.), nitrides (Si₃N₄, AlN, AlOₓN_{y}, etc.), tellurides (CdTe, etc.) and selenides (PbSe), and/or the like. In various examples, the thickness of the color-modulating layer 26 may range from 1nm or less to 5000nm depending on various applications.

By providing color-modulating layer 26 over the anti-reflection layer 16, desirable visual effect may be achieved without suffering from conversion efficiency loss and using complicated manufacturing methods. In some examples, the color-modulating layer 26 can decrease reflective loss so as to enhance solar power conversion efficiency.

Thereafter, a passivation layer 28 and a transparent layer 30 are sequentially formed to cover the color-modulating layer 26. The passivation layer 28 is a transparent film made of, preferably, ethylene vinyl acetate (EVA) or polyvinyl butyral (PVB) in order to prevent the solar cell unit from direct exposure to sun and rain or subject to humidity. The transparent layer 30 is preferably made of treated or nontreated glass.

It is noted that the step sequence of the aforementioned embodiment can be modified in consideration of practical use. For example, the formation of the electrodes 22 and 24 can be performed behind the formation of the color-modulating layer 26. Therefore, the exemplified embodiment cannot be used to interpret the scope of claims in limiting sense.

There are some examples are provided for reference as follows.

### Example I

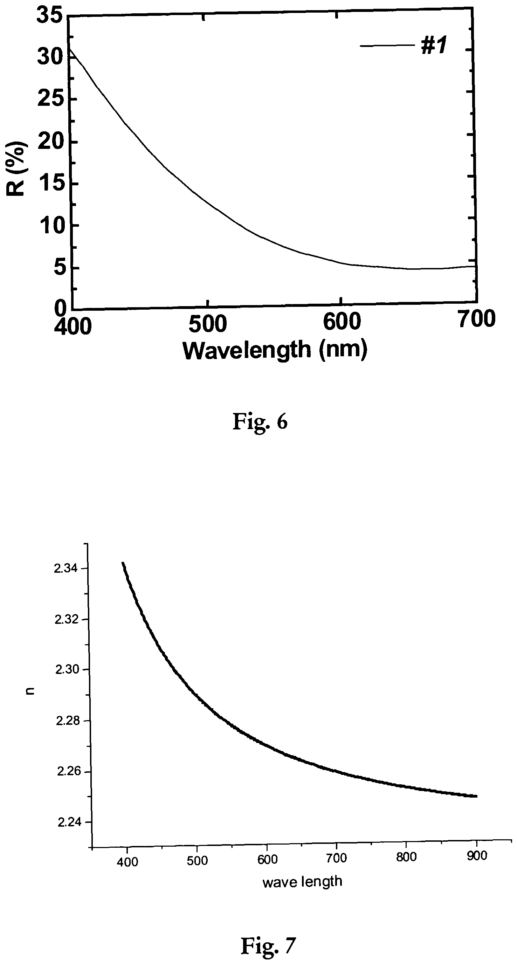

The photoelectric conversion layer 11 is made of a silicon layer of a first conductivity type formed in/on a silicon substrate of a second conductivity type. If the first conductivity type is p-type, the second conductivity type is n-type. To the contrary, the second conductivity type is p-type if the first conductivity type is n-type. As an example, the photoelectric conversion layer 11 is formed of silicon has a refractive index (n) in the range of 3.4∼3.6 and has thickness in the range of 140∼250 µm. The anti-reflective layer 16 is formed of silicon nitride having a refractive index (n) in the range of 1.8∼2.2 and a thickness in the range of 60∼120 nm. It is noted that no color-modulating layer 26 is formed to overlie the underlying layers to be compared with Examples II, III and IV. Accordingly, the reflective spectrum thereof is measured and illustrated in Figure 6. The CIE *L*a*b** values thereof are measured to be 34.92, 1.73 and -29.49, respectively.

### Example II

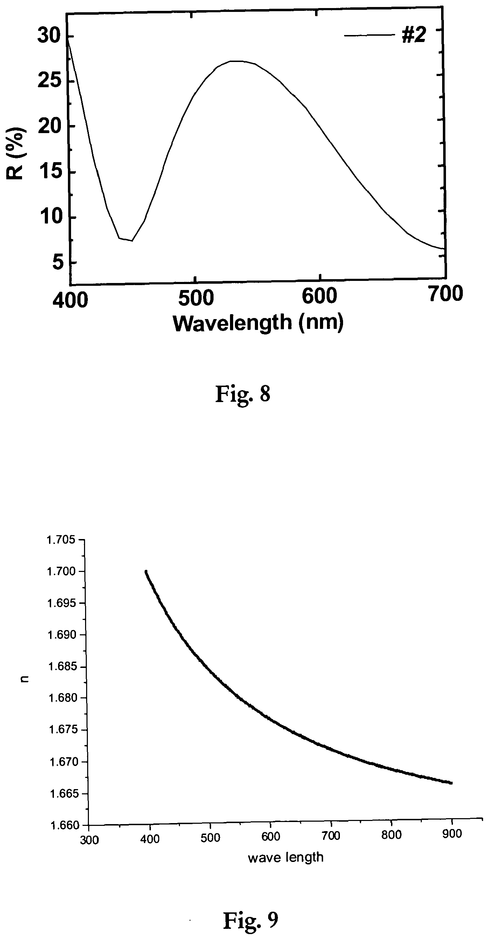

The photoelectric conversion layer 11 is made of a silicon layer of a first conductivity type formed in/on a silicon substrate of a second conductivity type. If the first conductivity type is p-type, the second conductivity type is n-type. To the contrary, the second conductivity type is p-type if the first conductivity type is n-type. As an example, the photoelectric conversion layer 11 is formed of silicon has a refractive index (n) in the range of 3.4∼3.6 and has thickness in the range of 140∼250 µm. The anti-reflective layer 16 is formed of silicon nitride having a refractive index (n) in the range of 1.8∼2.2 and a thickness in the range of 60∼120 nm. The color-modulating layer 26 is made of a material having a thickness of about 1,600∼2,000 Å and a refractive index vs. wavelength curve as shown in Figure 7. As such, the reflective spectrum thereof is measured and illustrated in Figure 8. The CIE *L*a*b** values are measured to be 56.65, -18.54 and 23.76, respectively. In other words, the color-modulating layer 26 is thicker than the anti-reflective layer 16.

### Examples III

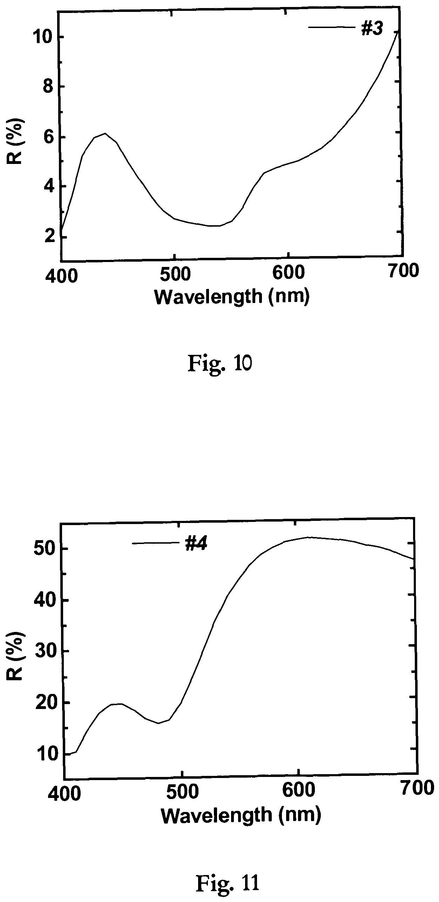

The photoelectric conversion layer 11 is made of a silicon layer of a first conductivity type formed in/on a silicon substrate of a second conductivity type. If the first conductivity type is p-type, the second conductivity type is n-type. To the contrary, the second conductivity type is p-type if the first conductivity type is n-type. As an example, the photoelectric conversion layer 11 is formed of silicon has a refractive index (n) in the range of 3.4∼3.6 and has thickness in the range of 140∼250 µm. The anti-reflective layer 16 is formed of silicon nitride having a refractive index (n) in the range of 1.8∼2.2 and a thickness in the range of 60∼120 nm. The color-modulating layer 26 is made of a material having a thickness of about 800∼1,200 Å and a refractive index vs. wavelength curve as shown in Figure 9. As such, the reflective spectrum thereof is measured and illustrated in Figure 10. The CIE *L*a*b** values are measured to be 22, 14.41 and -8.29, respectively.

### Examples IV

The photoelectric conversion layer 11 is made of a silicon layer of a first conductivity type formed in/on a silicon substrate of a second conductivity type. If the first conductivity type is p-type, the second conductivity type is n-type. To the contrary, the second conductivity type is p-type if the first conductivity type is n-type. As an example, the photoelectric conversion layer 11 is formed of silicon has a refractive index (n) in the range of 3.4∼3.6 and has thickness in the range of 140∼250 µm. The anti-reflective layer 16 is formed of silicon nitride having a refractive index (n) in the range of 1.8∼2.2 and a thickness in the range of 60∼120 nm. The color-modulating layer 26 is composed of multiple layers; that is, three layers are provided in this example. In the example, a first layer is provided with a refractive index (n1) in the range of 2.15∼2.55 and a thickness in the range of 750∼1100 Å; a second layer is provided with a refractive index (n2) in the range of 3.6∼4.0 and a thickness in the range of 1,550∼1,950 Å; a third layer is provided with a refractive index (n3) on the range of 2.15∼2.55 and a thickness in the range of 960∼1360 Å. The first, second and third layers are stacked sequentially from bottom to top. Therefore, the reflective spectrum thereof is measured and illustrated in Figure 11. The CIE *L*a*b** values are measured to be 47.05, 28.63 and -13.77, respectively. In other words, the color-modulating layer 26 is thicker than the anti-reflective layer 16.

The examples given hereinbefore show that the present invention provides those skilled in the art with the means to design solar cells with color-modulating layer having the most simple structure possible and sufficient efficiency, while exhibiting a predetermined color, so that they are well suited to serve as building material or whatever aesthetic appearance of which is an important requirement.

Although the invention has been described above by the embodiment and the examples, the invention is not limited to the foregoing embodiments and examples. The material of the color modulation is not always limited to any of the materials in the lists but can be freely sets as long as the external color of the solar cell can be adjusted by using color modulation property of the color colulating layer 26. More specifically, the material of the color modulating layer 26 may be, for example, oxides, fluorides, sulphides, nitrides, tellurides and selenides of a kind other than the kinds listed above, or a material other than oxides, fluorides, sulphides, nitrides, tellurides and selenides.

## Claims

1. A solar cell comprising:
- a photoelectric conversion layer (11) for generating electrical energy from incident light;
- an anti-reflection layer (16) formed over the photoelectric conversion layer (11);
- at least one first electrode (22) and at least one second electrode (24) formed over opposite surfaces of the photoelectric conversion layer (11) for outputting the electrical energy,
wherein the at least one first electrode (22) is provided in contact with the photoelectric conversion layer (11) through the anti-reflection layer (16), and a part of the first electrode (22) is disposed on a top surface of the anti-reflection layer (16); and
- a color-modulating layer (26) is uniformly deposited over the anti-reflection layer (16) to modulate colorful appearance thereof, wherein the color-modulating layer (26) overlies the at least one first electrode (22);
and wherein the color-modulating layer (26) is composed of a plurality of films, and the color-modulating layer (26) is thicker than the anti-reflection layer (16).

2. The solar cell as claimed in claim 1, wherein the color-modulating layer (26) comprises at least one of oxides, fluorides, sulphides, nitrides, tellurides and selenides.

3. The solar cell as claimed in claim 1, wherein the color-modulating layer (26) has a thickness in the range of about 1nm to 5000nm.

4. The solar cell as claimed in claim 1, wherein the photoelectric conversion layer (11) has a textured surface.

5. The solar cell as claimed in claim 1, wherein the photoelectric conversion layer (11) has a non-textured surface.

6. The solar cell as claimed in claim 1, further comprising a passivation layer (28) and a transparent layer (30) sequentially formed over the color-modulating layer (26).

7. The solar cell as claimed in claim 6, wherein the passivation layer (28) has a refractive index in the range of 1.4 to 1.6.

8. The solar cell as claimed in claim 7, wherein the passivation layer (28) is made of at least one of ethylene vinyl acetate (EVA) and polyvinyl butyral (PVB).

9. The solar cell as claimed in claim 6, wherein the transparent layer (30) has a refractive index in the range of 1.4 to 1.6.

10. The solar cell of claim 9, wherein the transparent layer (30) is made of glass.

11. A method of fabricating a solar cell as claimed in any one of the preceding claims, the method comprising:
- providing a photoelectric conversion layer (11);
- forming an anti-reflection layer (16) on the photoelectric conversion layer (11);
- forming at least one first electrode (22) and at least one second electrode (24) over the photoelectric conversion layer (11), wherein the first electrode (22) is formed on the anti-reflection layer (16);
- performing a heat treatment to the first electrode (22) and the first electrode passing through the anti-reflection layer (16) to be in contact with the photoelectric conversion layer (11) by spiking effect; and
- uniformly depositing a color-modulating layer (26) over the photoelectric conversion layer (11) and over the at least one first electrode (22) to modulate colorful appearance thereof.

## Patentansprüche

1. Solarzelle, welche umfasst:
- eine fotoelektrische Konversionsschicht (11)zum Erzeugen elektrischer Energie aus einfallendem Licht;
- eine Antireflexionsschicht (16) über der fotoelektrische Konversionsschicht (11) ausgebildet;
- mindestens eine erste Elektrode (22) und mindestens eine zweiten Elektrode (24), die über entgegengesetzten Oberflächen der fotoelektrischen Konversionsschicht (11) ausgebildet sind, zum Ausgeben der elektrischen Energie
worin die mindestens eine erste Elektrode (22) in Kontakt mit der fotoelektrischen Konversionsschicht (11)durch die Antireflexionsschicht (16) bereitgestellt wird, und ein Teil der ersten Elektrode (22) auf der oberen Oberfläche der Antireflexionsschicht (16) angeordnet ist; und
- eine gleichmäßig über der Antireflexionsschicht (16) angeordnete farbmodulierende Schicht (26), um Farberscheinungen davon zu modulieren, worin die farbmodulierende Schicht (26) die mindestens eine erste Elektrode (22) überlagert;
und worin die farbmodulierende Schicht (26) aus mehreren Schichten zusammengesetzt ist, und die farbmodulierende Schicht (26) dicker ist, als die Antireflexionsschicht (16).

2. Solarzelle nach Anspruch 1, worin die farbmodulierende Schicht (26) mindestens eins aus Oxiden, Fluoriden, Sulfiden, Nitriden, Telluriden und Seleniden umfasst.

3. Solarzelle nach Anspruch 1, worin die farbmodulierende Schicht (26) eine Dicke im Bereich von etwa 1nm bis 5000 nm aufweist.

4. Solarzelle nach Anspruch 1, worin die fotoelektrische Konversionsschicht (11) eine strukturierte Oberfläche aufweist.

5. Solarzelle nach Anspruch 1, worin die fotoelektrische Konversionsschicht (11) eine nicht-strukturierte Oberfläche aufweist.

6. Solarzelle nach Anspruch 1, welche weiter eine Passivierungsschicht (28) und eine transparente Schicht (30), aufeinanderfolgend über der farbmodulierenden Schicht (26) ausgebildet, umfasst.

7. Solarzelle nach Anspruch 6, worin die Passivierungsschicht (28) einen Brechungsindex im Bereich von 1,4 bis 1,6 aufweist.

8. Solarzelle nach Anspruch 7, worin die Passivierungsschicht (28) aus mindestens einem aus Ethylenvinylacetat (EVA) und Polyvinylbutyral (PVB) besteht.

9. Solarzelle nach Anspruch 6, worin die transparente Schicht (30) einen Brechungsindex im Bereich von 1,4 bis 1,6 aufweist.

10. Solarzelle nach Anspruch 9, worin die transparente Schicht (30) aus Glas besteht.

11. Verfahren zu Herstellung einer Solarzelle nach einem der vorstehenden Ansprüche, wobei das Verfahren umfasst:
- Bereitstellen einer fotoelektrischen Konversionsschicht (11);
- Ausbilden einer Antireflexionsschicht (16) auf der fotoelektrischen Konversionsschicht (11);
- Ausbilden mindestens einer ersten Elektrode (22) und mindestens einer zweiten Elektrode (24) über der fotoelektrischen Konversionsschicht (11), worin die erste Elektrode (22) auf der Antireflexionsschicht (16) ausgebildet ist;
- Durchführen einer Hitzebehandlung an der ersten Elektrode (22) und worin die erste Elektrode durch die Antireflexionsschicht (16) geht, um durch Spiking-Effekte in Kontakt mit der fotoelektrischen Konversionsschicht (11) zu kommen; und
- gleichmäßiges Auftragen einer farbmodulierenden Schicht (26) über der fotoelektrischen Konversionsschicht (11) und über der mindestens einen ersten Elektrode (22), um Farberscheinungen davon zu modulieren.

## Revendications

1. Cellule solaire comprenant :
- une couche de conversion photoélectrique (11) pour générer de l'énergie électrique à partir d'une lumière incidente ;
- une couche antireflet (16) formée sur la couche de conversion photoélectrique (11) ;
- au moins une première électrode (22) et au moins une seconde électrode (24) formées sur des surfaces opposées de la couche de conversion photoélectrique (11) pour délivrer l'énergie électrique,
l'au moins une première électrode (22) étant disposée en contact avec la couche de conversion photoélectrique (11) à travers la couche antireflet (16), et une partie de la première électrode (22) est disposée sur une surface supérieure de la couche antireflet (16) ; et
- une couche de modulation de couleur (26) est déposée uniformément sur la couche antireflet (16) pour moduler l'apparence colorée de celle-ci, la couche de modulation de couleur (26) recouvrant l'au moins une première électrode (22) ;
et la couche de modulation de couleur (26) étant composée d'une pluralité de films, et la couche de modulation de couleur (26) est plus épaisse que la couche antireflet (16).

2. Cellule solaire selon la revendication 1, la couche de modulation de couleur (26) comprenant au moins l'un parmi les oxydes, les fluorures, les sulfures, les nitrures, les tellurures et les séléniures.

3. Cellule solaire selon la revendication 1, la couche de modulation de couleur (26) ayant une épaisseur se situant dans la plage d'environ 1 nm à 5000 nm.

4. Cellule solaire selon la revendication 1, la couche de conversion photoélectrique (11) ayant une surface texturée.

5. Cellule solaire selon la revendication 1, la couche de conversion photoélectrique (11) ayant une surface non texturée.

6. Cellule solaire selon la revendication 1, comprenant en outre une couche de passivation (28) et une couche transparente (30) formées de manière séquentielle sur la couche de modulation de couleur (26).

7. Cellule solaire selon la revendication 6, la couche de passivation (28) ayant un indice de réfraction se situant dans la plage de 1,4 à 1,6.

8. Cellule solaire selon la revendication 7, la couche de passivation (28) étant constituée d'au moins l'un parmi l'éthylène-acétate de vinyle (EVA) et le polyvinylbutyral (PVB).

9. Cellule solaire selon la revendication 6, la couche transparente (30) ayant un indice de réfraction se situant dans la plage de 1,4 à 1,6.

10. Cellule solaire selon la revendication 9, la couche transparente (30) étant en verre.

11. Procédé de fabrication d'une cellule solaire selon l'une quelconque des revendications précédentes, le procédé comprenant :
- fournir une couche de conversion photoélectrique (11);
- former une couche antireflet (16) sur la couche de conversion photoélectrique (11);
- former au moins une première électrode (22) et au moins une seconde électrode (24) sur la couche de conversion photoélectrique (11), la première électrode (22) étant formée sur la couche antireflet (16) ;
- réaliser un traitement thermique sur la première électrode (22) et la première électrode passant à travers la couche antireflet (16) pour être en contact avec la couche de conversion photoélectrique (11) par effet de pointe ; et
- déposer uniformément une couche de modulation de couleur (26) sur la couche de conversion photoélectrique (11) et sur ladite au moins une première électrode (22) pour moduler l'aspect coloré de celle-ci.
